# EUROPÄISCHE PATENTSCHRIFT

(11) **EP 1 211 807 B1**
(45) Veröffentlichungstag und Bekanntmachung des Hinweises auf die Patenterteilung: **28.05.2003**
(21) Anmeldenummer: 01124478.7
(22) Anmeldetag: 12.10.2001
(51) Int. Cl.: H03K 5/003

(54) **Digitale Pegelanpassung**
Digital level adaptation circuit
Circuit numérique d'adaptation de niveau

(30) Priorität: 29.11.2000 DE 10059309
(43) Veröffentlichungstag der Anmeldung: 05.06.2002
(73) Patentinhaber: Phoenix Contact GmbH & Co. KG, 32825 Blomberg (DE)
(72) Erfinder: Esch, Rainer, Dipl.-Ing., 32825 Blomberg (DE)

(56) Entgegenhaltungen:
- EP-A- 0 533 340
- EP-A- 0 616 430
- DE-A- 19 644 772
- US-A- 5 568 062
- US-A- 6 028 447
- PATENT ABSTRACTS OF JAPAN vol. 013, no. 463 (E-833), 19. Oktober 1989 (1989-10-19) & JP 01 181223 A (NEC CORP), 19. Juli 1989 (1989-07-19)
- U.TIETZE, CH. SCHENK: "Halbleiter-Schaltungstechnik 11., völlig neu bearbeitete und erweiterte Auflage" , SPRINGER VERLAG , BERLIN, HEIDELBERG XP002186983 * Seite 638 - Seite 639, Abschnitt "Tristate-Ausgänge" *

## Beschreibung

Die Erfindung betrifft eine Schaltung zur ausgangsseitigen Pegelanpassung zwischen einem hochintegrierten programmierbaren Baustein mit niedriger Signalspannung und einem Mikroprozessorsystem mit hoher Signalspannung.

Im Zuge der Weiterentwicklung der Halbleitertechnologie in Form von Funktionalität, Schaltgeschwindigkeit und Schaltungsdichte in integrierten Schaltkreisen wurden die Versorgungs- und Signalspannungen immer wieder herabgesetzt.

Da in elektronischen Schaltungen auf Leiterplatten hochintegrierte Halbleiterkomponenten mit unterschiedlichen Versorgungs- und Signalspannungen verwendet werden, ist eine Pegelanpassung der für die Verbindung zwischen diesen hochintegrierten Halbleiterkomponenten zuständigen Signale notwendig. Werden in einer elektronischen Schaltung Komponenten verwendet, welche nur eine Versorgungsspannung benötigen, wie z.B. CMOS-Pegel 5 V, so ist eine Pegelanpassung nicht notwendig.
Müssen zum Beispiel die Ausgangssignale aus einem FPGA (Field Programable Gate Array), welches aufgrund der Schaltungsdichte mit 3,3 V versorgt wird, an eine Komponente mit 5 V Versorgungsspannung und CMOS-Eingangspegel angeschlossen werden, werden ohne Pegelanpassung die Ausgangssignale von der CMOS Komponente nicht erkannt. Das FPGA generiert den "1" Zustand mit beispielsweise 2,4 V, während die sichere "1" Erkennung der CMOS-Komponente bei 4,2 V liegen kann. Es muß also eine Pegelanpassung erfolgen, die den Signalpegel des "1" - Zustandes über die Eingangsschwelle für die Erkennung des "1" - Zustandes an der CMOS-Komponente anhebt.
Hierzu gibt es die Möglichkeit, einen Open Drain Ausgang mit Pullup- Widerstand nach Xilinx "The Programable Logic Data Book", 1999 zu verwenden. Eine weitere Beschreibung eines Open Drain Ausgangs befindet sich in Motorola "High - Speed CMOS Logic Data", 1988. Dieser Ausgang schaltet nur im "0"-Zustand den Ausgang gegen Ground. Im "1" - Zustand ist der Ausgang hochohmig, so daß nur der an die höhere Betriebsspannung angeschlossene Pullup-Widerstand die Signalleitung auf den höheren Signalpegel anhebt. Ein entscheidender Nachteil ist, daß die Schaltzeit bei groß gewählten Widerständen recht lang ist. Um die Schaltzeit zu verkürzen, muß der Pullup-Widerstand verkleinert werden, was wiederum zum Nachteil der erhöhten Stromaufnahme im "0" - Zustand führt. Ein Pullup-Widerstand von beispielsweise 1000 Ohm führt bei einem nach "0"geschaltetem Ausgang zu einem Signalstrom von 5 mA. Dieser Signalstrom summiert sich entsprechend bei einer Vielzahl von pegelangepassten Signalen zu einem sehr großen Summenstrom.
In "U. Tietze, Ch. Schenk:"Halbleiter-Schaltungstechnik 11., völlig neu bearbeitete und erweiterte Auflage" , Springer Verlag, Berlin, Heidelberg XP 00218683" ist eine TRI-State-Ausgang einer digitalen Schaltung beschrieben. Hierbei wird der "0" Signalzustand oder der "1"-Signalzustand als echter Gegentakt-Ausgang getrieben, wobei der "1"- Zustand dem vorgesehenen Pegel für dieses Bauteil entspricht.
Das Beschalten einer echten Gegentakt-Ausgangsstufe eines mit geringer Versorgungsspannung versorgten integrierten Schaltkreises mit einem Pullup-Widerstand kann je nach internem Aufbau der Gegentakt-Ausgangsstufe zu einem unerwünschtem Querstrom führen. Der Querstrom resultiert aus den Widerstandswert des Pullup-Widerstandes und der Spannungsdifferenz zwischen der ersten niedrigeren Signalspannung und der zweiten höheren Signalspannung. Im besonders ungünstigen Fall kann der Querstrom die Gegentakt-Ausgangsstufe zerstören.

Eine zuverlässige und vom Schaltverhalten schnelle Möglichkeit der Signalpegelanpassung ist die Verwendung einer Levelshifter-Komponente, welche im Datenblatt Texas Instruments "SN54CBTD3384, SN74CBTD3384 10-Bit FET Bus Switches with Level Shifting", 1995, revised 1998, beschrieben ist. Der Ausgang der Komponente mit niedriger Signalspannung wird mit dem Eingang der Levelshifter-Komponente verbunden. Der Ausgang der Levelshifter-Komponente wird wiederum mit dem Eingang der Komponente mit hoher Signalspannung verbunden. Der entscheidende Nachteil ist, daß eine oder mehrere Levelshifter-Komponenten zusätzlich in die Gesamtschaltung eingesetzt werden müssen, welche zusätzlichen Platz auf der Leiterplatte benötigen und sich kostenerhöhend auf die elektronische Schaltung auf Leiterplatte auswirkt. Auch die in DE 196 44 772 C2 beschriebene Schaltung zur Pegelanpassung, welche kostengünstig sein soll, hat den Nachteil, daß pro zu wandelndes Signal je 4 Widerstände und zwei Bipolartransistoren benötigt werden. Bei breiten parallelen pegelangepassten Systembussen sind eine Vielzahl von Einzelbauteilen notwendig, die den Platzbedarf auf der Leiterplatte für die elektronische Schaltung erhöhen und einen Bestückungsmehraufwand bei der Herstellung verursachen. Auch die mögliche Signalverzerrung und die Signalbelastung dieser in DE 196 44 772 C2 beschriebenen Pegelanpassung ist für schnelle parallele Systembusse nicht tolerierbar. Ausschließlich für den in DE 196 44 772 C2 beschriebenen Verwendungszweck, zwei integrierte Schaltkreise mit unterschiedlichen Signalspannungen über einen I2C-Bus mit nur einer geringen Signalanzahl zusammen zu schalten, ist die in DE 196 44 772 C2 beschriebene kostengünstige Transistorschaltung zwar ausreichend, jedoch bei einer großen Signalanzahl mit Pegelanpassung ist diese Anordnung zu aufwendig und damit nachteilig.

Der Erfindung liegt die Aufgabe zugrunde, eine kostengünstige, platzsparende Pegelanpassung zwischen einem hochintegrierten programmierbaren Baustein FPGA mit niedriger Signalspannung und einem Mikroprozessorsystem mit hoher Signalspannung zu realisieren. Die Pegelanpassung muß aufgrund der geringen Größe des zur Verfügung stehenden Platzes keine oder nur eine geringe Anzahl kleiner Bauteile umfassen. Die Verwendung von käuflichen integrierten Komponenten soll aus Kostengründen hierbei vermieden werden.

Die Aufgabe wird erfindungsgemäß durch die in den Ansprüchen 1 bis 4 angegebenen Merkmale gelöst. An dem Ausgang des hochintegrierten programmierbaren Bausteins FPGA mit niedriger Signalspannung wird ein Pullup-Widerstand geschaltet. Intern erfolgt in digitaler Weise eine Verknüpfung des internen Ausgangssignals mit dem vom Ausgangspad rückgekoppelten Ausgangssignal derart, daß bei einem Signal-Zustandswechsel von "0" nach "1" der Ausgangspegel bis zum "1" Wert der niedrigen Signalspannung der Ausgangstreibers aktiv treibt, nach Erreichen des "1"-Zustandes für den niedrigen Signalpegel wird der Ausgangstreiber hochohmig geschaltet (TRI-State), so dass für die restlich verbleibende Pegelanhebung bis zum hohen Signalpegel nur der Pullup-Widerstand wirkt. Der Pullup-Widerstand muß also nicht über den gesamten hohen Signalpegelhub wirken, sondern nur über die verbleibenden Differenzbetrag zwischen dem niedrigen Signalpegel des Ausgangstreibers und dem "1" Schwellwert des Eingangs mit hohem Signalpegel. Die langsame Anstiegszeit bei einer Open Drain Schaltung ist in dieser Anwendung auf eine für die Funktion ausreichende Zeit verkürzt. Der Pullup-Widerstand kann einen um zweifach bis vierfach höheren Wert erhalten, als bei einer ausschließlichen Open Drain Beschaltung, wodurch die Strombelastung durch die Signalströme gering bleibt.

Die erfindungsgemäße Schaltung zur Pegelanpassung ist auch noch funktionsfähig bei der Verwendung von hochintegrierten programmierbaren Bausteinen mit einer Versorgungsspannung von 2,5 V. Eine geringfügig längere Signalanstiegszeit ist dabei zu tolerieren, da der über den Pullup-Widerstand anzuhebende Signalpegel größer ist.

Ein weiterer Vorteil dieser Erfindung ist, dass sie auch in maskenprogrammierbaren integrierten Schaltkreisen wie Gate Arrays oder nach Kundenapplikation hergestellten integrierten Schaltkreisen (Standard Cell oder Full Custom IC) angewendet werden kann. In diesem Falle sind die Eingangs/Ausgangsblöcke als Analog-Applikation hergestellt und beinhalten vom Hersteller des digitalen Schaltkreises vorgefertigte und geprüfte Schaltungsteile, während die digitale Pegelanpassung mit den digitalen Logikgattern sich im kundenspezifischen Digitalteil befindet. Mit dieser Erfindung müssen bei solchen Schaltkreisen für eine Pegelanpassung keine neuen Eingangs/Ausgangsblöcke als Analog-Applikation hergestellt und geprüft werden.

Im folgenden wird die Erfindung anhand eines Ausführungsbeispiels und den dazugehörigen Figuren beschrieben.
Fig. 1: zeigt die erfindungsgemäße Ansteuerungsschaltung einer Ausgangszelle in einem hochintegrierten programmierbaren Baustein FPGA.
Fig. 2: zeigt das Signalverhalten in den einzelnen Anschnitten der Ausgangszelle im FPGA.
Fig. 3: Zeigt das Signalverhalten bei einer herkömmlichen Open-Drain-Beschaltung (Stand der Technik).
Fig. 4: zeigt eine Variante der erfindungsgemäßen Ansteuerschaltung für eine bidirektionale Anwendung in einem hochintegrierten programmierbaren Baustein FPGA.

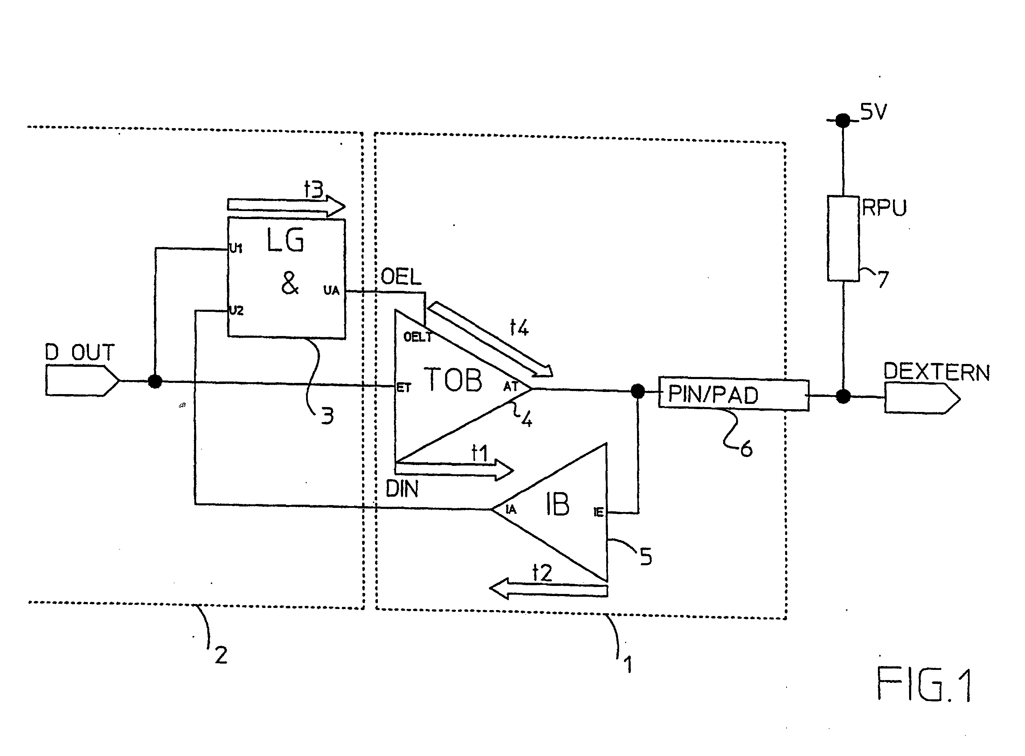

In **FIG. 1** ist die erfindungsgemäße Ansteuerschaltung mit dem Ausgangstreiber und Eingangsschaltung in einem FPGA mit niedriger Signalspannung und 3,3 V Versorgungsspannung dargestellt.

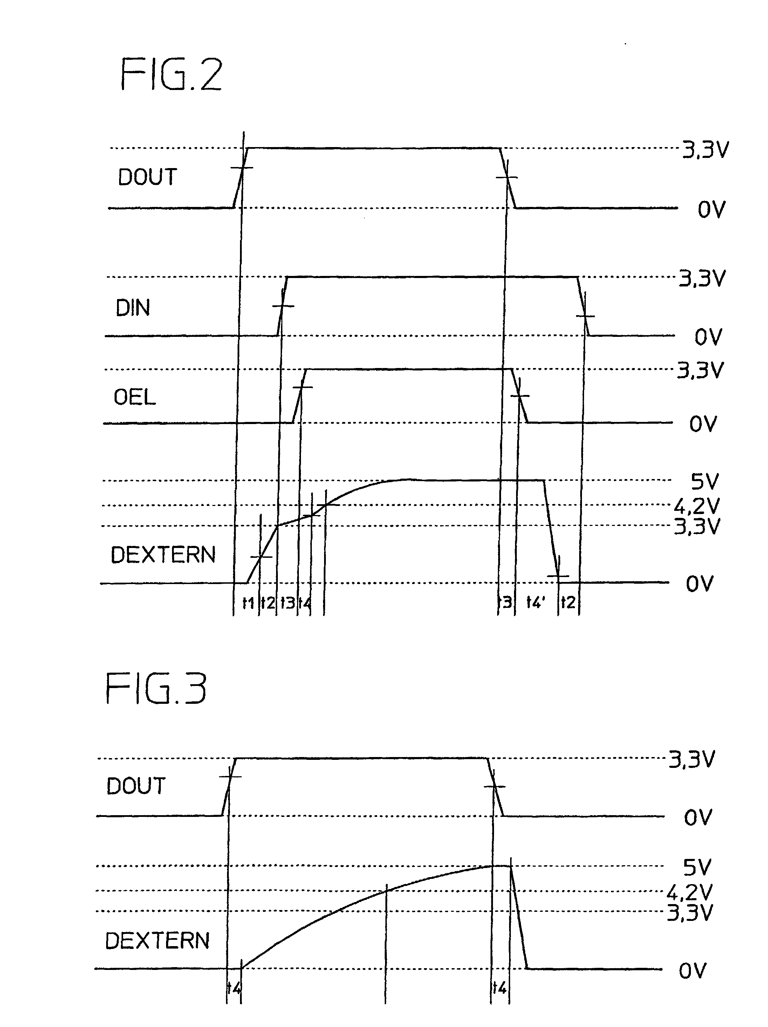

Die Ansteuerung des Ausgangstreibers **4** erfolgt über das im FPGA-Digitalteil **2** erzeugten Signal OEL. Der vom Ausgangstreiber **4** erzeugte Ausgangssignalverlauf wird in den Digitalteil **2** des FPGA über den im Eingangs/Ausgangs Block **1** vorhandenen Eingangspuffer **5** wieder zurückgeführt und einem digitalem UND-Gatter **3** zugeführt. Der Eingangspuffer **5** wirkt um einige ns verzögernd auf das Signal DIN. Eine parametrierbare Eingangsverzögerung ist je nach Typ des Eingangs/Ausgangs Blocks **1** und des FPGAs ebenfalls möglich. Das interne digitale Ausgangssignal DOUT und das rückgekoppelte Ausgangssignal DIN liegen eingangsseitig am UND-Gatter **3**. Der Ausgang OEL des UND-Gatters **3** ist am Low-aktiven Freigabeeingang OELT des Ausgangstreibers **4** geschaltet, so daß beim aus dem Digitalteil **2** erzeugten Signal DOUT mit "1"-Zustand und dem über den Ausgangstreiber **4** zurückgekoppelten und verzögerten Ausgangssignal DIN die Freigabe des Ausgangstreibers **4** gesteuert wird. Über den PIN/PAD **6** wird das Ausgangssignal DEXTERN aus dem FPGA oder maskenprogrammierbaren integrierten Schaltkreis nach außen, außerhalb des Bausteins, geführt. In **Fig. 2** ist das Signalverhalten der internen Signale und Ausgangssignale im Zeitverhalten dargestellt. Im folgenden wird anhand der **FIG. 2** mit Bezug der Bezeichnungen von **Fig. 1** die Ansteuerung in Schritten verdeutlicht:
Schritt 1: Der Ausgangstreiber **4** wird durch das interne im Digitalteil **2** erzeugte Signal DOUT auf "0" durchgeschaltet, am Eingang U1 des UND-Gatters **3** liegt ebenfalls der "0"-Zustand des Signals DOUT an. Durch die UND-Verknüpfung **3** wird das Freigabesignal OEL auf "0" gehalten, wodurch der Ausgangstreiber **4** den momentanen DOUT Zustand "0" auf seinen Ausgang AT durchschaltet. Der Zustand des rückgekoppelten Ausgangssignals DIN hat ebenfalls den Zustand "0" und liegt am zweiten Eingang U2 des digitalen UND-Gatters **3**, wodurch das Ausgangssignal DEXTERN ebenfalls den Zustand "0" hat.
Schritt 2: Jetzt erfolgt der Schaltbeginn zur Umschaltung des Signals DEXTERN vom "0"-Zustand zum Zustand "1". Das intern im Digitalteil **2** erzeugte Signal DOUT wird auf "1" umgeschaltet. Am ersten Eingang U1 des UND-Gatters **3** liegt mit DOUT eine "1" an, am zweiten Eingang U2 des UND-Gatters **3** liegt das zurückgekoppelte und um t1 plus t2 verzögerte Ausgangssignal DIN an, welches noch einen "0"-Zustand hat. Die Verzögerung t1 wird durch die Gatterlaufzeit des Ausgangstreibers **4** erzeugt, die Verzögerung t2 wird durch die Gatterlaufzeit des Eingangspuffers **5** erzeugt. Damit hat der OEL-Ausgang des UND-Gatters **3** immer noch den "0"-Zustand, wodurch der Ausgangstreiber **4** den jetzigen "1"-Zustand des internen Ausgangssignals DOUT um die Verzögerungszeit t1 später auf seinen Ausgang AT ausgibt.
Schritt 3: Die Verzögerungszeiten t1 plus t2, die im Bereich der Anstiegszeit des Ausgangssignals, zum Beispiel 5 ns betragen könnten, sind abgelaufen. Am UND-Gatter **3** liegt an einem Eingang U1 mit DOUT eine "1", am anderen Eingang U2 des UND-Gatters **3** liegt das zurückgekoppelte und verzögerte Ausgangssignal DIN, welches jetzt einen "1"-Zustand hat. Damit bekommt der OEL-Ausgang des UND-Gatters **3** den "1"-Zustand, wodurch der Ausgangstreiber **4** nach Ablauf der Verzögerungszeit t4 abgeschaltet bzw. hochohmig geschaltet wird. Die Zeit t4 ist die Verzögerungszeit vom Aktivieren oder deaktivieren des Aktivierungseinganges OELT am Ausgangstreiber **4** bis zur Wirkung am Ausgang AT.
Schritt 4: Nach dem Abschalten des Ausgangstreibers **4** sorgt ausschließlich der Pullup-Widerstand **7** dafür, daß die Signalspannung nach der getriebenen Anstiegszeit t1 die restliche Pegelanhebung bis zum Eingangsschwellwert der Komponente mit hoher Signalspannung erreicht. Der dafür notwendige Zeitbedarf ist mit t5 bezeichnet. Zum Vergleich ist in **Fig. 3** der zeitliche Verlauf eines Signalwechsels einer Standard-Open-Drain Ausgangsschaltung dargestellt. In dieser Schaltung wird um die Schaltzeit des Open-Drain-Ausgangs t4 verzögert der Ausgang hochohmig geschaltet. Danach erreicht der über einen Pullup-Widerstand auf "1" angehobene Ausgang nach der Zeit t5 den für eine CMOS Komponente erkennbaren Eingangsschwellwert von beispielsweise 4,2 V. Die gesamte Verzögerungszeit t4 plus t5 ist in dieser Anordnung wesentlich länger, als die Summe der Verzögerungszeiten t1, t2, t3, t4 und t5 in der erfindungsgemäßen Anordnung.
Schritt 5: In diesem Schritt erfolgt die Umschaltung des Signals DOUT vom "1"-Zustand in den "0"-Zustand. Nachdem das interne digitale Ausgangssignal DOUT wieder den "0"-Zustand annimmt, erreicht das Freigabesignal OEL am Eingang OELT des Ausgangstreibers **4** um t3 verzögert den "0" Zustand und aktiviert um t4 verzögert den Ausgang AT, wodurch das Signal DEXTERN den Zustand "0" annimmt. Das über den Eingangspuffer **5** zurückgekoppelte und verzögerte Ausgangssignal DIN erreicht um die weitere Zeit t2 den Zustand "0", der für diese Umschaltung jedoch nicht mehr relevant ist.

Wie in **Fig.1** zu erkennen ist, erfolgt die Realisierung im FPGA durch die Programmierung der I/O-Zelle für eine bidirektionale Funktion. In der Eingangsschaltung wird eine Verzögerungszeit t2 in der Größenordnung von beispielsweise 5 ns eingestellt. Die Verknüpfung des internen Ausgangssignals DOUT mit dem zurückgekoppelten Ausgangssignals DIN erfolgt in einem UND-Gatter **3** oder einer Schaltung, welche die gleichartige Funktionalität zum Erzeugen des Freigabesignals OEL für den Ausgangstreiber **4** bereitstellt. Die Verknüpfung zur Ansteuerung des Ausgangstreibers **4** erfolgt damit im Digitalteil **2** des FPGAs, so daß in der vorliegenden Erfindung von einer digitalen Pegelanpassung gesprochen werden kann.

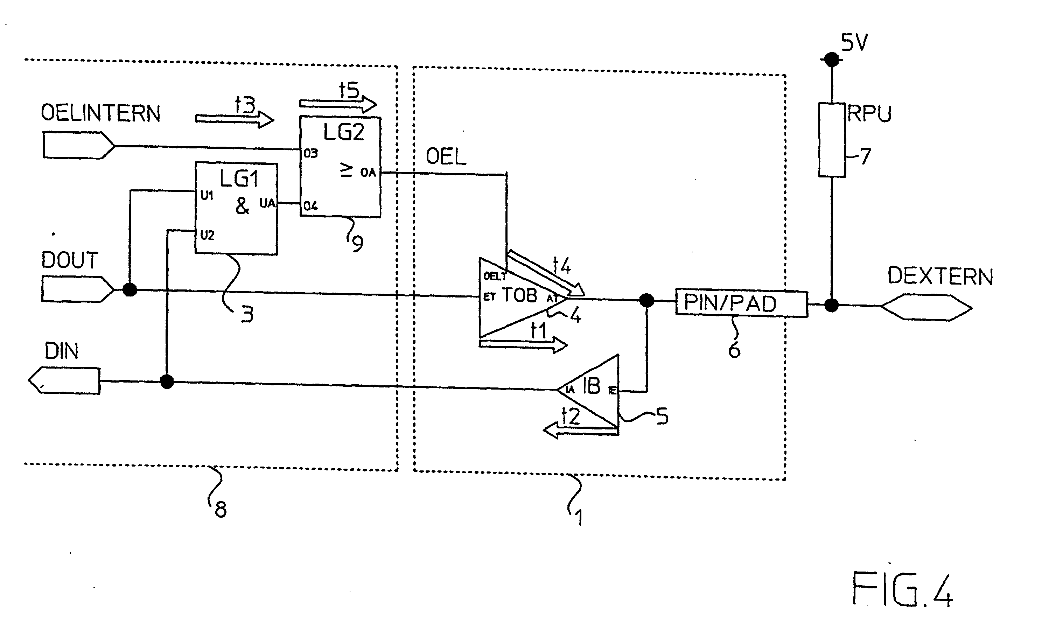

In **Fig.4** ist eine Variante für eine ausgangsseitige Pegelanpassung mit bidirektionaler Funktion. In dieser Variante wird aus dem Digitalteil **8** des FPGA das Signal OELINTERN für das Einschalten des Ausgangstreibers **4** generiert. Dieses Freigabesignal OELINTERN wird dabei an den Eingang O3 des zusätzliches Logikgatters **9** mit der logischen ODER-Funktion gelegt. Am zweiten Eingang O4 liegt das Freigabesignal, welches aus der UND-Verknüpfung **3** aus dem internen Datensignal DOUT und dem zurückgekoppelten und verzögerte Ausgangssignal DIN resultiert. Ist der bidirektionale Eingangs/Ausgangs-Block **1** als Ausgang geschaltet, so ist die digital gesteuerte Funktion der Pegelanpassung aktiviert, da OELINTERN den Zustand "0" hat und somit ausschließlich die UND-Verknüpfung **3** zum Erzeugen des Freigabesignals OEL zum Durchschalten des Ausgangstreibers **4** wirkt. Ist der bidirektionale Eingangs/Ausgangs-Block **1** als Eingang geschaltet, so hat das im Digitalteil **8** erzeugte Steuersignal OELINTERN den Zustand "1". Damit wird durch die nachgeschaltete ODER-Verknüpfung **9** das Freigabesignal OEL immer in den Zustand "1" hält, und die digital gesteuerte Funktion der Pegelanpassung kann nicht auf das Freigabesignal OEL wirken. Jeder logische Zustand am Pin DEXTERN wird über den Eingangspuffer 5 in den Digitalteil **8** übertragen, wobei das Freigabesignal OEL für den Ausgangstreiber **4** nicht durch den Eingangssignalzustand DIN beeinflußt wird.

## Patentansprüche

1. Schaltung zur ausgangsseitigen Pegelanpassung eines integrierten Schaltkreises mit niedriger Signalspannung an einen integrierten Schaltkreis mit hoher Signalspannung mit einem an dem pegelanzupassenden Signal (DEXTERN) angeschlossenen Pullup-Widerstand (7) zum Anheben des Ausgangssignals vom niedrigen Signalpegel auf den hohen Signalpegel,
**dadurch gekennzeichnet,**
**dass** im Zeitraum, nachdem das Ausgangssignal den getriebenen "1"-Zustand des niedrigen Signalpegels erreicht hat, die Pegelanhebung um die Pegeldifferenz zwischen dem niedrigen Signalpegel und dem hohen Signalpegel des Ausgangssignals (DEXTERN) aus einem Ausgangstreiber (4) über den Pullup-Widerstand (7) erfolgt und der Ausgangstreiber (4) inaktiv geschaltet ist.

2. Schaltung nach Anspruch 1,
**dadurch gekennzeichnet,**
**dass** der Ausgang (AT) des Ausgangstreibers (4) während des Schaltens vom "0"-Zustand in den "1"-Zustand seinen "1"-Zustand
zum PIN/PAD (6) aktiv treibt und
nach Erreichen des ausgangsseitigen maximalen "1"-Signalpegels des niedrigen Signalpegels der Ausgang (AT) in den hochohmigen Zustand (TRI-State) geschaltet wird.

3. Schaltung nach Anspruch 1 oder 2,
**dadurch gekennzeichnet,**
**dass** die logische Verknüpfung (3, 9) zum Erzeugen des Freigabesignals für den Ausgangstreiber mit digitalen Logikgattern erfolgt.

4. Schaltung nach Anspruch 1 oder 2,
**dadurch gekennzeichnet,**
**dass** für den Ausgangstreiber (4) und für den rückgekoppelten Eingang (5) die vorhandenen Schaltungsteile einer Eingangs/Ausgangs-Zelle (1) eines FPGA verwendet werden.

5. Schaltung nach Anspruch 1 oder 2,
**dadurch gekennzeichnet,**
**dass** für den Ausgangstreiber (4) und für den rückgekoppelten Eingang (5) die vorhandenen Schaltungsteile einer Eingangs/Ausgangs-Zelle (1) eines nach Vorgabe maskenprogrammierbaren integrierten Schaltkreises verwendet werden.

6. Schaltung nach Anspruch 3,
**dadurch gekennzeichnet,**
**dass** der Aufbau der digitalen Verknüpfung (3, 9) zum Erzeugen des Ansteuersignals (OEL) für einen Ausgangstreiber (4) mit Logikelementen im programmierbaren Digitalteil (2, 8) eines FPGA erfolgt.

7. Schaltung nach Anspruch 3,
**dadurch gekennzeichnet,**
**dass** der Aufbau der digitalen Verknüpfung (3, 9) zum Erzeugen des Ansteuersignals (OEL) für einen Ausgangstreiber (4) mit Logikelementen im Digitalteil (2, 8) eines nach Vorgabe maskenprogrammierbaren integrierten Schaltkreises erfolgt.

8. Schaltung nach Anspruch 3,
**dadurch gekennzeichnet,**
**dass** der Aufbau der digitalen Verknüpfung (3, 9) zur Ansteuerung eines Ausgangstreibers für die Pegelanpassung eine mit einzelnen Standardlogikelementen extern aufgebaute digitale Schaltung ist.

9. Schaltung nach einem der Ansprüche 1 bis 8,
**dadurch gekennzeichnet,**
**daß** die Schaltung zur ausgangsseitigen Pegelanpassung eines integrierten Schaltkreises mit niedriger Signalspannung an einen integrierten Schaltkreis mit hoher Signalspannung in einer Eingangs/Ausgangs-Zelle (1) für eine bidirektionale Anwendung mit bidirektionaler Funktionalität zum Digitalteil (8) eingesetzt wird.

## Claims

1. A circuit for level adjustment on the output side of an integrated circuit having low signal voltage to an integrated circuit having high signal voltage (DEXTERN) with a pullup resistor (7) connected to the signal to be adjusted, to increase the output signal from the low signal level to the high signal level,
**characterised in that**,
for the period after the output signal has reached the driven "1" state of the low signal level, the level is increased across pull-up resistor (7) by the level difference between the low signal level and the high signal level of the output signal (DEXTERN) from an output driver (4), and the output driver (4) is switched to inactive.

2. The circuit according to claim 1,
**characterized in that**
the output (AT) from output driver (4) actively drives its "1" state at PIN/PAD (6) during switching from the "0" state to the "1" state and when the output-side maximum "1" signal level of the low signal level is reached, output (AT) is switched to the highly resistive state (TRI-state).

3. The circuit according to claim 1 or 2,
**characterized in that**
the logical switching operation (3, 9) for generating the release signal for the output driver is assured by digital logic gates.

4. The circuit according to claim 1 or 2,
**characterized in that**
the available circuit components of an I/O cell (1) of an FPGA are used for the output driver (4) and for the feedback-looped input (5).

5. The circuit according to claim 1 or 2,
**characterized in that**
the available circuit components of an I/O cell (1) of an integrated circuit that can be programmed to specifications via a mask are used the output driver (4) and for the feedback-looped input (5).

6. The circuit according to claim 3,
**characterized in that**
the construction of the digital logic operation (3, 9) for generating the control signal (OEL) for an output driver (4) is provided by logic elements in the programmable digital part (2, 8) of an FPGA.

7. The circuit according to claim 3,
**characterized in that**
the construction of the digital logic operation (3, 9) for generating the control signal (OEL) for an output driver (4) is provided by logic elements in the digital part (2, 8) ) of an integrated circuit that can be programmed to specifications via a mask.

8. The circuit according to claim 3,
**characterized in that**
the construction of the digital logic operation (3, 9) for controlling an output driver for level adjustment is a digital circuit that is constructed externally using standard logic elements.

9. The circuit according to any of claims 1 to 8,
**characterized in that**
the circuit for level adjustment on the output-side of an integrated circuit having low signal voltage to an integrated circuit having high signal voltage is used in an I/O cell (1) for bidirectional application with bidirectional functionality to the digital part (8).

## Revendications

1. Circuit pour adaptation des niveaux du côté de la sortie d'un circuit intégré ayant une faible tension de signal à un circuit intégré ayant une tension de signal élevée avec une résistance d'excursion haute (7) reliée au signal dont le niveau doit être adapté (DEXTERN), afin d'élever le signal de sortie de faible niveau de signal jusqu'au niveau de signal élevé,
**caractérisé en ce que**,
dans l'intervalle de temps, après que le signal de sortie ait atteint l'état "1" piloté de faible niveau de signal, l'élévation de niveau de la différence de niveau entre le faible niveau de signal et le niveau de signal élevé du signal de sortie (DEXTERN) est réalisée par la résistance d'excursion haute (7) à partir d'un étage de sortie (4) et l'étage de sortie (4) est commuté sur l'état inactif.

2. Circuit selon la revendication 1,
**caractérisé en ce que**,
l'entrée (AT) de l'étage de sortie (4) pendant la commutation de l'état "0" dans l'état "1", pilote de façon active son état "1" jusqu'à PIN/PAD (6) et après avoir atteint le niveau de signal maximal "1" du côté de la sortie du faible niveau de signal, la sortie (AT) est commutée sur l'état à haute résistance (TRI-State).

3. Circuit selon la revendication 1 ou 2,
**caractérisé en ce que**,
le couplage logique (3, 9) pour produire le signal de déverrouillage destiné à l'étage de sortie est réalisé par des portes logiques numériques.

4. Circuit selon la revendication 1 ou 2,
**caractérisé en ce que**,
les parties de circuit disponibles d'une cellule d'entrée/sortie (1) d'un FPGA sont employées pour l'étage de sortie (4) et pour l'entrée (5) ramenée.

5. Circuit selon la revendication 1 ou 2,
**caractérisé en ce que**,
les parties de circuit disponibles d'une cellule d'entrée/sortie (1) d'un circuit intégré à masque programmable d'après une directive sont employées pour l'étage de sortie (4) et pour l'entrée ramenée (5).

6. Circuit selon la revendication 3,
**caractérisé en ce que**,
la structure du couplage numérique (3, 9) pour produire le signal de commande (OEL) destiné à un étage de sortie (4) est réalisée par des éléments logiques dans la partie numérique programmable (2, 8) d'un FPGA.

7. Circuit selon la revendication 3,
**caractérisé en ce que**,
la structure du couplage numérique (3, 9) pour produire la signal de commande (OEL) destiné à un étage de sortie (4) est réalisée par des éléments logiques dans la partie numérique (2, 8) d'un circuit intégré à masque programmable d'après une directive.

8. Circuit selon la revendication 3,
**caractérisé en ce que**,
la structure du couplage numérique (3, 9) pour commander un étage de sortie destiné à l'adaptation de niveaux est un circuit numérique constitué de façon externe par des éléments logiques classiques individuels.

9. Circuit selon l'une quelconque des revendications 1 à 8,
**caractérisé en ce que**,
le circuit pour l'adaptation de niveaux du côté de la sortie d'un circuit intégré ayant une faible tension de signal à un circuit intégré ayant une tension de signal élevée, est mis en oeuvre dans une cellule d'entrée/sortie (1) pour une application bidirectionnelle avec une fonctionnalité bidirectionnelle en direction de la partie numérique(8).
